# EUROPÄISCHE PATENTSCHRIFT

(11) **EP 1 307 931 B1**
(45) Veröffentlichungstag und Bekanntmachung des Hinweises auf die Patenterteilung: **29.10.2014**
(21) Anmeldenummer: 01964884.9
(22) Anmeldetag: 09.08.2001
(51) Int. Cl.: H01L 27/00, H01L 51/05, H01L 27/28, G11C 13/00, B82Y 10/00

(54) **SPEICHERELEMENT UND VERFAHREN ZUM HERSTELLEN EINES SPEICHERELEMENTS**
MEMORY ELEMENT AND METHOD FOR PRODUCTION OF A MEMORY ELEMENT
ELEMENT DE MEMOIRE ET SON PROCEDE DE PRODUCTION

(30) Priorität: 09.08.2000 DE 10038889
(43) Veröffentlichungstag der Anmeldung: 07.05.2003
(73) Patentinhaber: Qimonda AG, 81739 München (DE)
(72) Erfinder: HOFMANN, Franz, 80995 München (DE); LUYKEN, Richard, Johannes, 81825 München (DE); RÖSNER, Wolfgang, 85521 Ottobrunn (DE)
(74) Vertreter: Viering, Jentschura & Partner Patent- und Rechtsanwälte
(86) Internationale Anmeldenummer: PCT/DE2001/003037
(87) Internationale Veröffentlichungsnummer: WO 2002/013284

(56) Entgegenhaltungen:
- WO-A-97/30445
- DE-A- 2 314 193
- US-A- 5 831 276

## Beschreibung

Die Erfindung betrifft ein Speicherelement sowie ein Verfahren zum Herstellen eines Speicherelements.

Ein solches Speicherelement sowie ein Verfahren zum Herstellen eines solchen Speicherelements sind aus [1] bekannt.

Bei dem aus [1] bekannten Speicherelement sind organische Komplexe zur elektrischen Kopplung erster Leitungen, in einer ersten Metallisierungs-Schicht mit zweiten Leitungen in einer zweiten Metallisierungs-Schicht vorgesehen. Die organischen Komplexe werden jedoch während der einzelnen Herstellungsprozesse der weiteren Komponenten des Speicherelements, insbesondere vor der Herstellung zumindest eines Teils der Verdrahtungsebenen und Metallisierungs-Schichten und der entsprechenden Kontaktierungen in das Speicherelement eingebracht.

Beispiele für solche organischen Komplexe, deren elektrische Leitfähigkeit sich aufgrund einer an die organischen Komplexe, das heißt an das organische Material, angelegten elektrischen Spannung bis um den Faktor 10⁴ ändern kann, sind beispielsweise aus [2] als N-(3-Nitrobenzyliden)-p-Phenylendiamin (NBPDA) bzw. als System der beiden Materialien 3-Nitrobenzalmalonitril (NBMN) und 1,4-Phenylendiamin (pDA) bekannt.

Ein weiteres organisches Material, welches seine elektrische Leitfähigkeit aufgrund einer an das Material angelegten elektrischen Spannung ändert, ist aus [3] als Rotaxan bekannt.

Diese organischen Materialien sind sehr empfindlich und können leicht beschädigt werden, insbesondere hinsichtlich ihres Verhaltens bezüglich der Änderung ihrer elektrischen Leitfähigkeit.

Ein Nachteil des aus [1] bekannten Speicherelements ist somit insbesondere darin zu sehen, dass das während der teilweise unter großer Hitze durchgeführten Verfahrensschritte im Rahmen des Herstellungsverfahrens des Speicherelements, beispielsweise während eines Siliziumprozesses eingebrachte organische Material durch die Hitze sehr leicht beschädigt wird.

Ein solches organisches Speicherelement ist somit sehr störungsanfällig und in seinen elektrischen Eigenschaften nicht sehr robust.

Weiterhin ist aus [4] eine Speicherzellenanordnung und deren Verwendung als magnetisches RAM-Speicherelement und als assoziativer Speicher bekannt.

Ferner ist aus [4] eine Ansteuer-Schaltung der einzelnen Speicherzellen des magnetischen RAM-Speicherelements bekannt zum Einschreiben und Auslesen binärer Information über Wort-Leitungen und Bit-Leitungen in die jeweiligen Speicherzellen.

beschreibt eine Speicheranordnung mit einem Film aus organischem Material.

beschreibt einen ROM-Speicher mit einem Substrat, auf welchem Substrat Elektroden aufgebracht sind. Zwischen den Elektroden ist eine Schicht angeordnet. Der ROM-Speicher besteht aus konjugierten Polymeren oder Oligomeren sowie Dotieratomen.

Weitere elektrisch adressierbare Speichermedien sind in [7], [8], [9], [10], [11], [12], [13] und [14] beschrieben.

Somit liegt der Erfindung das Problem zugrunde, ein Speicherelement mit organischen Materialien anzugeben, sowie ein Verfahren zum Herstellen eines solchen Speicherelements, welches Speicherelement verglichen mit dem aus [1] bekannten Speicherelement eine geringere Störungsanfälligkeit aufweist.

Ein Speicherelement weist ein Substrat auf, in dem üblicherweise schon einzelne Transistoren und elektrische Komponenten des Speicherelements enthalten sind. Auf dem Substrat, beispielsweise einem Substrat aus Silizium, ist eine erste Metallisierungs-Schicht, vorzugsweise aus Gold, sowie auf der ersten Metallisierungs-Schicht eine erste Isolations-Schicht aufgebracht. Auf der ersten Isolations-Schicht, vorzugsweise hergestellt aus Plasmadioxid oder Plasmanitrid, ist eine zweite Metallisierungs-Schicht aufgebracht, ebenfalls vorzugsweise aus Gold.

Die erste Metallisierungs-Schicht und die zweite Metallisierungs-Schicht sind übereinander in zueinander parallelen Ebenen angeordnet, so dass die einzelnen Metallisierungs-Schichten einander nicht berühren. Die erste Metallisierungs-Schicht ist derart strukturiert, dass in ihr erste elektrische Leitungen, die voneinander jeweils durch beispielsweise die erste Isolations-Schicht elektrisch isoliert sind, gebildet sind.

Ferner sind in der zweiten Metallisierungs-Schicht zweite elektrische Leitungen gebildet, die derart über den ersten Leitungen der ersten Metallisierungs-Schicht angeordnet sind, dass diese sich kreuzen, jedoch aufgrund der zwischen ihnen angeordneten ersten Isolations-Schicht nicht elektrisch kontaktieren.

An zumindest einem Teil der Kreuzungsstellen zwischen der ersten Leitung und einer zweiten Leitung ist jeweils ein Graben gebildet, der die erste Leitung zumindest teilweise überlappt und die zweite Leitung unmittelbar koppelt, vorzugsweise vollständig überlappt.

Unter einer Kreuzungsstelle ist beispielsweise eine Stelle zu verstehen, an der durch Errichten im wesentlichen eines Lots auf einer der beiden Leitungen jeweils die andere Leitung ebenfalls berührt wird.

Jeder Graben, zumindest ein Teil der Gräben, ist mit einem organischen Füllmaterial, das organische Komplexe enthält, gefüllt, dessen elektrische Leitfähigkeit durch eine elektrisch angelegte Spannung veränderbar ist. Die Veränderung sollte so stark und dauerhaft sein, dass zwei unterschiedliche Zustände des organischen Materials entsprechend einer angelegten Spannung und keiner angelegten Spannung, leicht und robust erfassbar sein sollte, um ein verlässliches Einschreiben und Auslesen binärer Information in die bzw. aus der jeweiligen Speicherzelle gewährleistet ist.

In diesem Zusammenhang eignen sich alle organischen Materialien deren elektrische Leitfähigkeit sich insbesondere um bis zu einen Faktor 10⁴ verändern kann, vorzugsweise um bis zu einen Faktor 10³ oder 10².

Das Füllmaterial kann als organische Komplexe vorzugsweise die aus [2] und [3] bekannten Materialien
- Rotaxan, und/oder
- N-(3-Nitrobenzyliden)-p-Phenylendiamin (NDPDA), und/oder
- ein System der Materialien 3-Nitrobenzalmalonitril (NBMN) und 1,4-Phenylendiamin (pDA),
enthalten.

Unterhalb der beiden Metallisierungs-Schichten, das heißt beispielsweise zwischen den Metallisierungs-Schichten und dem Substrat oder sogar unterhalb des Substrats kann eine elektronische Peripherie-Schaltung angeordnet sein, die es ermöglicht, auf sehr robuste und störungsunanfällige Weise das Speicherelement, insbesondere die einzelnen durch jeweils ein in einen Graben gefülltes Füllmaterial gebildeten Speicherzellen, eindeutig anzusprechen, beispielsweise einen binären Wert in eine Speicherzelle einzuschreiben oder aus ihr auszulesen.

Die binäre Information ist in diesem Speicherelement in der entsprechenden Leitfähigkeit des Füllmaterials, welches in dem jeweiligen Graben zwischen den beiden Leitungen, die die Wort-Leitungen bzw. Bit-Leitungen des Speicherelements darstellen, gegeben.

Auf diese Weise wird ein Speicherelement mit organischen Komplexen angegeben, welches störungsunanfällig ist und eine sehr hohe Integrationsdichte aufweist, da eine Speicherzelle einen minimalen Platzbedarf von 4 * F * F (F = Feature size), das heißt die jeweils minimale Strukturierungsgröße des eingesetzten Herstellungsprozesses, aufweist.

Wird Gold für die einzelnen Leitungen verwendet, so ist ein Vorteil des Speicherelements unter anderem darin zu sehen, dass mittels beispielweise der bekannten Gold-Schwefel-Kopplung die entsprechenden organischen Materialien sehr gut auf den elektrischen Leitungen binden, insbesondere mittels einer kovalenten Bindung.

Ein weiterer Vorteil bei Einsatz von Gold für die einzelnen Leitungen ist darin zu sehen, dass die Oberflächen der einzelnen Leitungen nicht bzw. in nur sehr geringem Maß oxidieren.

Das Speicherelement weist insbesondere den Vorteil auf, dass die organischen Komplexe erst nach der Silizium-Prozessierung eingebaut werden müssen, wodurch eine Schädigung des organischen Materials bei einer hohen Temperaturbelastung, die bei einzelnen Siliziumelement-Herstellungsschritten erforderlich ist, auftritt.

Da die gesamte Peripherieschaltung unterhalb des jeweiligen Zellenfeldes angeordnet sein kann, wird die ferner aktive, das heißt vollständig für das Speicherelement nutzbare Chipfläche weiter vergrößert.

Das Speicherelement kann zusätzliche Verdrahtungsschichten aufweisen, um die einzelnen in den Siliziumsubstrat vorgesehenen elektronischen Bauelemente miteinander elektronisch zu koppeln.

Weiterhin kann zwischen dem Substrat und der ersten Metallisierungs-Schicht eine zweite Isolations-Schicht vorgesehen sein, um das Substrat und die erste Metallisierungs-Schicht, das heißt insbesondere die ersten elektrischen Leitungen voneinander elektrisch zu isolieren.

Bei einem Verfahren zum Herstellen eines Speicherelements wird auf einem Substrat eine erste Metallisierungs-Schicht aufgebracht und derart strukturiert, dass erste Leitungen gebildet werden, die mit dem Substrat in elektrischen Kontakt gebracht werden. Dies kann beispielsweise dadurch erfolgen, dass zwischen den ersten Leitungen und das Substrat durch eine dazwischen vorgesehene zweite Isolations-Schicht hindurch Kontaktlöcher gebildet werden, wodurch die ersten Leitungen mit dem Substrat elektrisch kontaktiert werden können. Auf der ersten Metallisierungs-Schicht wird eine erste Isolations-Schicht aufgebracht und auf der ersten Isolations-Schicht eine zweite Metallisierungs-Schicht, die derart strukturiert wird, dass zweite Leitungen gebildet werden, die die ersten Leitungen zwar nicht elektrisch koppeln, diese jedoch oberhalb der ersten Leitungen kreuzen. Zumindest an einem Teil der Kreuzungsstellen zwischen den ersten Leitungen und den zweiten Leitungen wird ein Graben gebildet, der jeweils die erste Leitung teilweise überlappt und die zweite Leitung koppelt, das heißt vorzugsweise vollständig überlappt. Die Gräben werden mit einem oben beschriebenen organischen Füllmaterial, das organische Komplexe enthält, gefüllt, so dass über das Füllmaterial die ersten Leitungen und die zweiten Leitungen jeweils elektrisch miteinander koppelbar sind. Das Füllmaterial weist, wie oben dargestellt, eine aufgrund einer angelegten elektrischen Spannung sich erheblich verändernde Leitfähigkeit auf.

Ein Ausführungsbeispiel der Erfindung ist in den Figuren dargestellt und wird im weiteren näher erläutert.

Es zeigen:

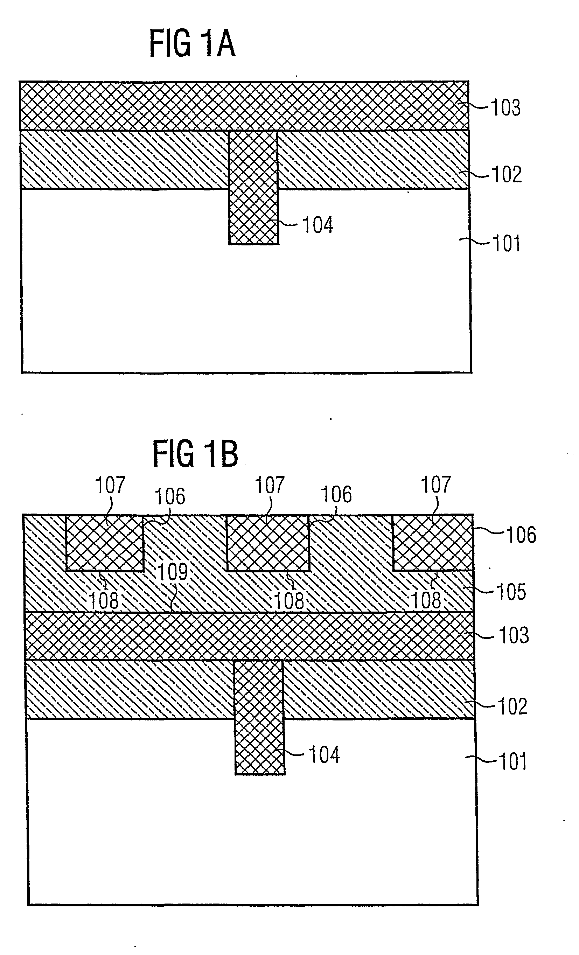

- Figuren 1a bis 1d: jeweils einen Querschnitt durch ein Speicherelement zu unterschiedlichen Zeitpunkten während dessen Herstellung.

**Fig.1a** zeigt ein Substrat 101, in dem schon die einzelnen elektronischen Bauelemente, die für ein Speicherelement zu dessen Ansteuerung, insbesondere die erforderlichen MOS-Feldeffekttransistoren (nicht dargestellt), enthalten sind.

Auf dem Substrat 101, welches gemäß diesem Ausführungsbeispiel aus Silizium hergestellt ist, wird mittels eines Abscheideverfahrens aus der Gasphase (CVD-Verfahren) oder alternativ mittels eines Sputter-Verfahrens oder eines Aufdampf-Verfahrens eine Isolations-Schicht 102 (hierin auch als zweite Isolations-Schicht bezeichnet) aufgebracht, vorzugsweise aus Siliziumnitrid.

Die Isolations-Schicht 102 weist eine Dicke von ungefähr 300 nm bis 700 nm auf, wobei in diesem Zusammenhang anzumerken ist, das die Dicke der Isolations-Schicht 102 im wesentlichen für die Funktionalität der Erfindung unerheblich ist und frei gewählt werden kann.

Nach einem ersten Photolithographieverfahren werden Kontaktlöcher 104 geätzt. Anschließend werden Gräben mit einer Tiefe von ungefähr 100 nm bis 200 nm in die Isolations-Schicht 102 geätzt.

Weiterhin wird für den Fall, dass in einem folgenden Schritt ein Abscheideverfahren aus einer Flüssigkeit verwendet wird, eine elektrisch leitende Schicht auf der Isolations-Schicht 102 abgeschieden.

In einem weiteren Schritt wird eine erste Metallisierungs-Schicht 103 aus Gold auf die Isolations-Schicht 102 bzw. die elektrisch leitende Schicht aufgebracht, vorzugsweise mittels eines Abscheideverfahrens aus einer Flüssigkeit (Electroplating), alternativ mittels eines Sputter-Verfahrens oder eines Aufdampf-Verfahrens.

Bei der Abscheidung des Goldes, allgemein des Metalls zum Bilden der ersten Metallisierungs-Schicht 103, werden die Kontaktlöcher 104 und die Gräben mit Gold gefüllt.

Mittels eines chemisch-mechanischen Polierverfahrens (CMP-Verfahren) wird die erste Metallisierungs-Schicht 103 gebildet, indem soviel Gold entfernt wird, dass das Gold nur noch in den Gräben vorhanden ist. Damit sind die Leiterbahnen in der ersten Metallisierungs-Schicht 103 elektrisch voneinander getrennt.

Wie in **Fig.1b** dargestellt, wird anschließend auf die erste Metallisierungs-Schicht 103 eine Isolations-Schicht 105 (hierin auch als erste Isolations-Schicht bezeichnet) aufgebracht, gemäß diesem Ausführungsbeispiel aus Nitrid, welches mittels eines CVD-Verfahrens, eines Aufdampf-Verfahrens oder eines Sputter-Verfahrens aufgebracht wird.

Nach einem weiteren Photolithographieverfahren werden in die Isolations-Schicht 105 wiederum Kontaktlöcher geätzt.

In einem weiteren Schritt wird die Isolations-Schicht 105 mittels Photolithographie derart strukturiert, dass in ihr Gräben 106 geätzt werden, in die in einem anschließenden Verfahrensschritt nach Entfernen des für die Photolithographie verwendeten Photolacks eine zweite Metallisierungs-Schicht 107 gebildet wird, die gemäß diesem Ausführungsbeispiel wiederum aus Gold gebildet wird.

Bei der Abscheidung des Goldes werden sowohl die Kontaktlöcher als auch die Gräben 106 mit Gold gefüllt.

Mittels eines anschließenden CMP-Verfahrens wird das überstehende Gold entfernt, so dass nur noch in den Gräben 106 Gold vorhanden ist. Damit sind die gebildeten Leiterbahnen in der zweiten Metallisierungs-Schicht 107 elektrisch voneinander getrennt. Die gebildete zweite Metallisierungs-Schicht 107 weist eine Dicke von ungefähr 200 nm auf.

Die zweite Metallisierungs-Schicht 107 wird mittels eines Electroplating-Verfahrens, eines Sputter-Verfahrens oder eines Aufdampf-Verfahrens gebildet und die Gräben 106 werden zumindest teilweise gemäß der zweiten Strukturierung gebildet als zweite Metallisierungsschicht 107.

Bei Einsatz eines Electroplating-Verfahrens zum Bilden der zweiten Metallisierungs-Schicht 107 wird vor dem Electroplating eine weitere elektrisch leitende Schicht auf der Isolations-Schicht 105 abgeschieden.

Die Gräben 106 werden derart in die Isolations-Schicht 105 eingebracht, dass die Dicke der Isolations-Schicht 105 zwischen dem Boden 108 eines jeweiligen Grabens 106 und der oberen Oberfläche 109 der ersten Metallisierungs-Schicht 103 ungefähr 100 nm beträgt.

In einem weiteren Schritt wird mittels Photolithographie eine Maske erzeugt, in die in einem weiteren Schritt eine Vielzahl von Löchern 110 eingebracht wird mittels Trockenätzens. Die Löcher 110 entstehen nur an einander kreuzenden ersten Leitungen und zweiten Leitungen.

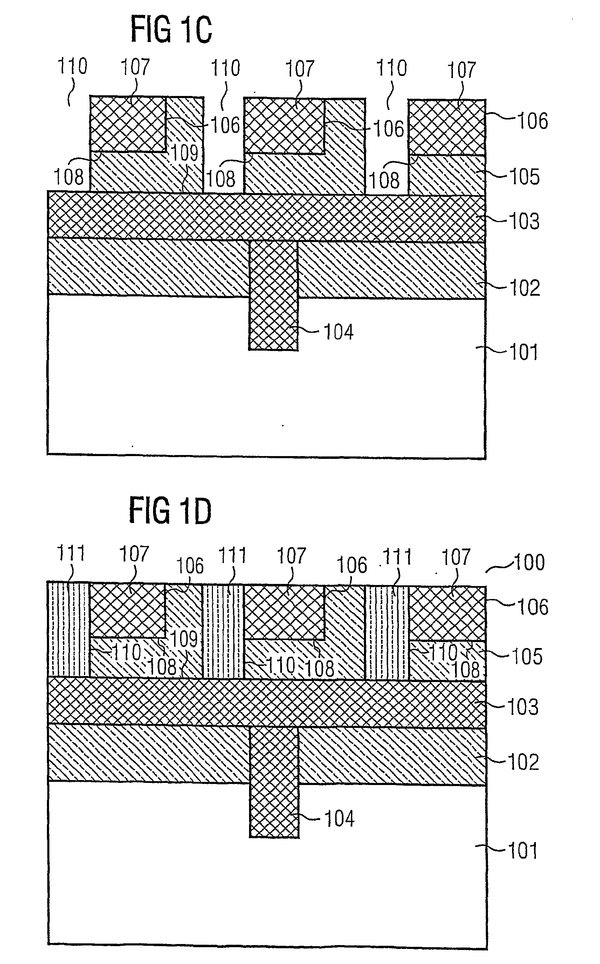

Die geätzten Löcher 110 bzw. Gräben 110 sind derart in dem gebildeten Speicherelement 100 angeordnet (vgl. **Fig.1c**), dass sie die ersten Leitungen der ersten Metallisierungs-Schicht 103 vollständig elektrisch Kontaktieren und die zweiten Leitungen der zweiten Metallisierungs-Schicht 107 teilweise durchdringen, beispielsweise dadurch, dass ein Randbereich oder allgemein ein Teilbereich einer zweiten Leitung durch Ätzen des jeweiligen Grabens 110 entfernt wird.

Die Gräben 106 weisen vorzugsweise einen Durchmesser von ungefähr 50 nm bis 100 nm auf; bei rechteckförmigen Gräben weisen die jeweiligen Seiten eines Grabens 110 jeweils ungefähr 50 nm bis 100 nm auf.

Es ist in diesem Zusammenhang darauf hinzuweisen, dass nur ein Teil der zweiten Leitung durch jeweils einen Graben 110 entfernt wird, so dass eine für die entsprechende elektrische Leitfähigkeit ausreichende zweite Leitung zurückbleibt, die mittels eines im weiteren erläuterten Schritts eingefüllten organischen Materials elektrisch kontaktierbar ist mit der jeweiligen ersten elektrischen Leitung der ersten Metallisierungs-Schicht 103.

Anschließend wird der Photolack entfernt, nachdem die Gräben 110 durch sowohl die zweite Metallisierungs-Schicht 107 als auch durch die Isolations-Schicht 105 geätzt wurde.

In einem letzten Schritt wird gemäß dem in [2] beschriebenen Verfahren N-(3-Nitro-Benzyliden)-p-Phenylendiamin als Füllmaterial 111 in die Gräben 110 abgeschieden.

Alternativ kann gemäß dem in [3] beschriebenen Verfahren Rotaxan als Füllmaterial 111 in das in **Fig.1d** dargestellte Speicherelement 110 abgeschieden werden.

In einem letzten Schritt wird das über die Gräben 110 hinausstehende Füllmaterial 111 rückgeätzt, das heißt entfernt.

Die ersten Leitungen bilden gemäß dem Ausführungsbeispiel die Wort-Leitungen und die zweiten Leitungen die Bit-Leitungen des Speicherelements 100.

Die Ansteuer-Schaltung der einzelnen durch die Wort-Leitungen und Bit-Leitungen der ersten Metallisierungs-Schicht 103 bzw. zweiten Metallisierungs-Schicht 107 und den mit dem Füllmaterial 111 gefüllten Gräben 110 gebildeten Speicherzellen des Speicherelements 100 ist gemäß dem vorliegendem Ausführungsbeispiel in gleicher Weise ausgebildet wie in [4] beschrieben.

In diesem Dokument sind folgende Veröffentlichungen zitiert:
[1] R.F. Service, Organic Molecule Rewires Chip Design, Science, Vol. 285, S. 313 - 315, 16. Juli 1999
[2] H.J. Gao et al., Reversible, Nanometer-Scale Conductance Transitions in an Organic Complex, Physical Review Letters, Vol. 84, No.8, S. 1780 - 1783, Februar 2000
[3] C.P. Collier et al., Electronically Configurable Molecular-Based Logic Gates, Sience 285, S. 391 - 394, 1999
[4] WO 99/14760 Al
[5] DE OS 2 314 193
[6] WO 97/30445
[7] US 6,055,180
[8] US 6,072,716
[9] US 4,876,668
[10] US 4,371,883
[11] JP 08-116 109 A
[12] JP 06-222 4961 A
[13] JP 04-414 5664 A
[14] US 5,831,276 A

### Bezugszeichenliste

100 Speicherelement
101 Substrat
102 Erste Isolations-Schicht
103 Erste Metallisierungs-Schicht
104 Kontaktloch
105 zweite Isolations-Schicht
106 Graben
107 Zweite Metallisierungs-Schicht
108 Boden Graben
109 Oberfläche erste Metallisierungs-Schicht
110 Graben
111 Füllmaterial

## Patentansprüche

1. Speicherelement
• mit einem Substrat (101),
• mit einer ersten Metallisierungsschicht (103),
• mit einer zweiten Metallisierungsschicht (107),
• bei dem die erste Metallisierungsschicht (103) und die zweite Metallisierungsschicht (107) übereinander in parallelen Ebenen angeordnet sind, wobei zwischen der ersten Metallisierungsschicht (103) und der zweiten Metallisierungsschicht (107) eine erste Isolationsschicht (105) angeordnet ist,
• wobei erste Leitungen in der ersten Metallisierungsschicht (103) und zweite Leitungen in der zweiten Metallisierungsschicht (107) zueinander kreuzend angeordnet sind,
• bei dem an zumindest einem Teil der Kreuzungsstellen zwischen einer ersten Leitung und einer zweiten Leitung ein Graben (110) gebildet ist, der die erste Leitung teilweise überlappt und die zweite Leitung koppelt, und
• bei dem der Graben (110) mit einem Füllmaterial (111) gefüllt ist, dessen elektrische Leitfähigkeit durch eine angelegte elektrische Spannung veränderbar ist,
• **dadurch gekennzeichnet, dass** das Füllmaterial (111) organische Komplexe enthält.

2. Speicherelement nach Anspruch 1,
bei dem das Füllmaterial (111) zumindest eines der folgenden Materialien enthält:
• Rotaxan,
• N-(3-Nitrobenzyliden)-p-Phenylendiamin (NBPDA), und/oder
• ein System der Materialien 3-Nitrobenzal-Malonitril (NBMN) und 1,4-Phenylendiamin (pDA).

3. Speicherelement nach einem der Ansprüche 1 bis 2, bei dem das Substrat (101) Silizium enthält.

4. Speicherelement nach einem der Ansprüche 1 bis 3,
bei dem die erste Metallisierungsschicht (103) und/oder die zweite Metallisierungsschicht (107) Gold enthält.

5. Speicherelement nach einem der Ansprüche 1 bis 4,
bei dem eine elektronische Peripherie-Schaltung unterhalb des Grabens (110) angeordnet ist.

6. Speicherelement nach einem der Ansprüche 1 bis 5,
• mit mindestens einer ersten Verdrahtungsschicht, und
• mit mindestens einer zweiten Verdrahtungsschicht.

7. Speicherelement nach einem der Ansprüche 1 bis 6,
bei dem zwischen dem Substrat (101) und der ersten Metallisierungsschicht (103) eine zweite Isolationsschicht (102) vorgesehen ist.

8. Speicherelement nach einem der Ansprüche 1 bis 7,
bei dem die erste Isolationsschicht (105) und/oder eine zwischen dem Substrat (101) und der ersten Metallisierungsschicht (103) vorgesehene zweite Isolationsschicht (102) Siliziumnitrid oder Siliziumdioxid enthält.

9. Verfahren zum Herstellen eines Speicherelements,
• bei dem auf einem Substrat (101) eine erste Metallisierungsschicht (103) aufgebracht wird und derart strukturiert wird, dass erste Leitungen gebildet werden, die mit dem Substrat (101) in elektrischen Kontakt gebracht werden,
• bei dem auf der ersten Metallisierungsschicht (103) eine erste Isolationsschicht (105) aufgebracht wird,
• bei dem auf der ersten Isolationsschicht (105) eine zweite Metallisierungsschicht (107) aufgebracht wird und derart strukturiert wird, dass zweite Leitungen gebildet werden, die die ersten Leitungen kreuzen,
• bei dem an zumindest einem Teil der Kreuzungsstellen zwischen einer ersten Leitung und einer zweiten Leitung ein Graben (110) gebildet wird, der die erste Leitung teilweise überlappt und die zweite Leitung koppelt,
• bei dem die Gräben (110) mit einem Füllmaterial (111) gefüllt werden, dessen elektrische Leitfähigkeit durch eine angelegte elektrische Spannung veränderbar ist,
• **dadurch gekennzeichnet, dass**
als Füllmaterial (111) organische Komplexe verwendet werden.

10. Verfahren nach Anspruch 9,
bei dem als das Füllmaterial (111) zumindest eines der folgenden Materialien verwendet wird:
• Rotaxan,
• N-(3-Nitrobenzyliden)-p-Phenylendiamin (NBPDA), und/oder
• ein System der Materialien 3-Nitrobenzal-Malonitril (NBMN) und 1,4-Phenylendiamin (pDA).

11. Verfahren nach einem der Ansprüche 9 bis 10,
bei dem als Substrat (101) Silizium verwendet wird.

12. Verfahren nach einem der Ansprüche 9 bis 11,
bei dem für die erste Metallisierungsschicht (103) und/oder die zweite Metallisierungsschicht (107) Gold verwendet wird.

13. Verfahren nach einem der Ansprüche 9 bis 12,
bei dem zwischen dem Substrat (101) und der ersten Metallisierungsschicht (103) eine zweite Isolationsschicht (102) eingebracht wird.

14. Verfahren nach Anspruch 13,
bei dem zwischen den ersten Leitungen und das Substrat (101) durch die zweite Isolationsschicht (102) hindurch Kontaktlöcher (104) gebildet werden.

## Claims

1. A memory element, comprising
• a substrate (101),
• a first metallization layer (103),
• a second metallization layer (107),
• in which the first metallization layer (103) and the second metallization layer (107) are arranged one above another in parallel planes, wherein a first insulation layer (105) is arranged between the first metallization layer (103) and the second metallization layer (107),
• wherein first lines in the first metallization layer (103) and second lines in the second metallization layer (107) are arranged to cross each other,
• in which at at least a part of the crossings between a first line and a second line a trench (110) is formed which partially overlaps the first line and couples the second line, and
• in which the trench (110) is filled with a filler material (111) which electrical conductivity is alterable by an applied electric voltage,
• **characterized in that**
the filler material (111) contains organic complexes.

2. The memory element of claim 1,
in which the filler material (111) contains at least one of the following materials:
• rotaxane,
• N-(3-nitrobenzylidene) p-phenylenediamine (NBPDA), and/or
• a system of the materials 3-nitrobenzal malonitrile (NBMN) and 1,4-phenylenediamine (PDA).

3. The memory element of one of the claims 1 or 2,
in which the substrate (101) contains silicon.

4. The memory element of one of the claims 1 to 3,
in which the first metallization layer (103) and/or the second metallization layer (107) contains gold.

5. The memory element of one of the claims 1 to 4, in which an electronic peripheral circuit is disposed below the trench (110).

6. The memory element of one of the claims 1 to 5,
• having at least a first wiring layer, and
• having at least a second wiring layer.

7. The memory element of one of the claims 1 to 6,
in which a second insulation layer (102) is provided between the substrate (101) and the first metallization layer (103).

8. The memory element of one of the claims 1 to 7,
in which the first insulation layer (105) and/or a second insultion layer (102) provided between the substrate (101) and the first metallization layer (103) contains silicon nitride or silicon dioxide.

9. A method for manufacturing a memory element,
• in which a first metallization layer (103) is deposited on a substrate (101) and structured such that first lines are formed which are brought into electrical contact with the substrate (101),
• in which a first insulation layer (105) is deposited on the first metallization layer (103),
• in which a second metallization layer (107) is deposited on the first insulation layer (105) and is structured such that second lines are formed which crosses the first lines,
• in which at at least a part of the crossings between a first line and a second line a trench (110) is formed which partially overlaps the first line and couples the second line, and
• in which the trenches (110) are filled with a filler material (111) which electrical conductivity is alterable by an applied electric voltage,
• **characterized in that**
the filler material (111) applies organic complexes.

10. The method according to claim 9,
in which at least one of the following materials is used as the filler material (111):
• rotaxane,
• N-(3-nitrobenzylidene) p-phenylenediamine (NBPDA), and/or
• a system of the materials 3-nitrobenzal malonitrile (NBMN) and 1,4-phenylenediamine (PDA).

11. The method according to one of the claims 9 or 10, in which silicon is used as substrate (101).

12. The method according to one of the claims 9 to 11,
in which gold is used for the first metallization layer (103) and/or the second metallization layer (107).

13. The method according to one of the claims 9 to 12,
in which a second insulation layer (102) is inserted between the substrate (101) and the first metallization layer (103).

14. The method according to claim 13,
in which contact holes (104) are formed through the second insulation layer (102) between the first lines and the substrate (101).

## Revendications

1. Elément de mémoire
• comprenant un substrat (101),
• comprenant une première couche (103) de métallisation,
• comprenant une deuxième couche (107) de métallisation,
• dans lequel la première couche (103) de métallisation et la deuxième couche (107) de métallisation sont disposées en étant l'une sur l'autre dans des plans parallèles, une première couche (105) isolante étant disposée entre la première couche (103) de métallisation et la deuxième couche (107) de métallisation,
• dans lequel des premières lignes dans la première couche (103) de métallisation et des deuxièmes lignes dans la deuxième couche (107) de métallisation sont entrecroisées les unes par rapport aux autres,
• dans lequel en au moins une partie des points d'intersection entre une première ligne et une deuxième ligne est formé un sillon (110) qui enjambe en partie la première ligne et qui couple la deuxième ligne et
• dans lequel le sillon (110) est empli d'une matière (111) de remplissage dont la conductivité électrique peut être modifiée par une tension électrique appliquée,
• **caractérisé en ce que**
la matière (111) de remplissage contient des complexes organiques.

2. Elément de mémoire suivant la revendication 1,
dans lequel la matière (111) de remplissage comprend au moins l'une des matières suivantes :
• du rotaxan,
• de la N-(3-nitrobenzylidène)-p-phénylènediamine (NBPDA), et/ou
• un système des matières 3-nitrobenzal-malonitrile (NBMN) et 1,4-phénylènediamine (pDA).

3. Elément de mémoire suivant l'une des revendications 1 à 2, dans lequel le substrat (101) contient du silicium.

4. Elément de mémoire suivant l'une des revendications 1 à 3, dans lequel la première couche (103) de métallisation et/ou la deuxième couche (107) de métallisation contiennent de l'or.

5. Elément de mémoire suivant l'une des revendications 1 à 4, dans lequel un circuit électronique périphérique est disposé en dessous du sillon (110).

6. Elément de mémoire suivant l'une des revendications 1 à 5,
• comprenant au moins une première couche de câblage, et
• comprenant au moins une deuxième couche de câblage.

7. Elément de mémoire suivant l'une des revendications 1 à 6, dans lequel une deuxième couche (102) isolante est prévue entre le substrat (101) et la première couche (103) de métallisation.

8. Elément de mémoire suivant l'une des revendications 1 à 7, dans lequel la première couche (105) isolante et/ou une deuxième couche (102) isolante prévue entre le substrat (101) et la première couche (103) de métallisation contiennent du nitrure de silicium ou du dioxyde de silicium.

9. Procédé de production d'un élément de mémoire,
• dans lequel on dépose une première couche (103) de métallisation sur un substrat (101) et on la structure de manière à former de premières lignes, qui sont mises en contact électrique avec le substrat (101),
• dans lequel on dépose une première couche (105) isolante sur la première couche (103) de métallisation,
• dans lequel on dépose une deuxième couche (107) de métallisation sur la première couche (105) isolante et on la structure de manière à former des deuxièmes lignes, qui croisent les premières lignes,
• dans lequel on forme, sur au moins une partie des points d'intersection entre une première ligne et une deuxième ligne, un sillon (110), qui enjambe en partie la première ligne et qui couple la deuxième ligne,
• dans lequel on remplit les sillons (110) d'une matière (111) de remplissage, dont la conductivité électrique peut être modifiée par une tension électrique appliquée,
• **caractérisé en ce que**
on utilise, comme matière (111) de remplissage, des complexes organiques.

10. Procédé suivant la revendication 9,
dans lequel on utilise, comme matière (111) de remplissage, au moins l'une des matières suivantes :
• du rotaxan,
• de la N-(3-nitrobenzylidène)-p-phénylènediamine (NBPDA), et/ou
• un système des matières 3-nitrobenzal-malonitrile (NBMN) et 1,4-phénylènediamine (pDA).

11. Procédé suivant l'une des revendications 9 à 10,
dans lequel on utilise du silicium comme substrat (101).

12. Procédé suivant l'une des revendications 9 à 11,
dans lequel on utilise de l'or pour la première couche (103) de métallisation et/ou pour la deuxième couche (107) de métallisation.

13. Procédé suivant l'une des revendications 9 à 12,
dans lequel on met une deuxième couche (102) isolante entre le substrat (101) et la première couche (103) de métallisation.

14. Procédé suivant la revendication 13,
dans lequel on forme des trous (104) de contact à travers la deuxième couche (102) isolante entre les premières lignes et le substrat (101).
